# EUROPÄISCHE PATENTSCHRIFT

(11) **EP 4 107 583 B1**
(45) Veröffentlichungstag und Bekanntmachung des Hinweises auf die Patenterteilung: **19.07.2023**
(21) Anmeldenummer: 21705507.8
(22) Anmeldetag: 15.02.2021
(51) Int. Cl.: G03F 7/20, G01N 1/02

(54) **PARTIKELPRÜFSYSTEM, PROJEKTIONSBELICHTUNGSANLAGE UND VERFAHREN ZUR PRÜFUNG EINER PARTIKELBELASTUNG EINER OBERFLÄCHE**
PARTICLE TEST SYSTEM, PROJECTION EXPOSURE APPARATUS AND METHOD FOR TESTING PARTICLE CONTAMINATION ON A SURFACE
SYSTÈME DE CONTRÔLE DE PARTICULES, INSTALLATION D'ÉCLAIRAGE PAR PROJECTION ET PROCÉDÉ POUR CONTRÔLER LA CHARGE EN PARTICULES D'UNE SURFACE

(30) Priorität: 17.02.2020 DE 102020201935
(43) Veröffentlichungstag der Anmeldung: 28.12.2022
(73) Patentinhaber: Carl Zeiss SMT GmbH, 73447 Oberkochen (DE)
(72) Erfinder: SCHILLING, Martin, 89233 Neu-Ulm (DE); ROOS, Matthias, 73431 Aalen (DE); NAGEL, Mona, 73431 Aalen (DE)
(74) Vertreter: Lorenz, Matthias
(86) Internationale Anmeldenummer: PCT/EP2021/053620
(87) Internationale Veröffentlichungsnummer: WO 2021/165192

(56) Entgegenhaltungen:
- US-A- 5 068 951
- US-A- 5 243 865
- US-A1- 2002 071 115
- US-B2- 7 017 397

## Beschreibung

Die vorliegende Anmeldung nimmt die Priorität der deutschen Patentanmeldung Nr. 10 2020 201 935.5 in Anspruch.

Die Erfindung betrifft ein Partikelprüfsystem zur Prüfung einer Partikelbelastung einer Oberfläche, aufweisend einen Beprobungsstreifen zur Aufnahme von Partikeln und eine Beprobungseinrichtung.

Die Erfindung betrifft ferner eine Projektionsbelichtungsanlage für die Halbleiterlithographie.

Die Erfindung betrifft auch ein Verfahren zur Prüfung einer Partikelbelastung einer Oberfläche sowie ein Computerprogrammprodukt mit Programmcodemitteln, um ein Verfahren zur Prüfung einer Partikelbelastung durchzuführen.

Partikelmessungen zur Erfassung der Partikelbelastung einer Oberfläche können in nahezu allen Bereichen der Naturwissenschaften und Technik sinnvoll angewendet werden. Die sich auf der zu untersuchenden Oberfläche angelagerten Partikel können im Rahmen der Partikelprüfung vollständig oder probeweise qualifiziert und/oder quantifiziert werden. Bei Partikeln handelt es sich in der Regel um Kleinkörper unterschiedlicher Natur, wie beispielsweise Metallabrieb, Kunststoffabrieb, Staub oder organische Substanzen - abhängig von der jeweiligen technischen Anwendung und der Umgebung.

Die Prüfung der Partikelbelastung einer Oberfläche ist insbesondere im Rahmen der Sicherstellung technischer Sauberkeit technischer Bauteile häufig erforderlich. Durch die Prüfung soll sichergestellt werden, dass die Partikelbelastung einer Oberfläche, beispielsweise aufgrund von Herstellung, Wartung und/oder Betrieb der technischen Bauteile, ausreichend gering ist, dass es zu keiner kurzfristigen oder langfristigen Funktionseinschränkung von technischen Anlagen kommt.

Insbesondere für Komponenten einer Projektionsbelichtungsanlage, beispielsweise für Oberflächen optischer Elemente oder mechanischer Bauteile, ist die Sicherstellung einer geringen Partikelbelastung mittlerweile von hoher Bedeutung. Aufgrund der fortschreitenden Miniaturisierung von Halbleiterschaltungen erhöhen sich die Anforderungen an Auflösung und Genauigkeit von Projektionsbelichtungsanlagen gleichermaßen. Entsprechend hohe Anforderungen werden auch an die dort verwendeten optischen Elemente, die unter anderem den Strahlengang innerhalb der Projektionsbelichtungsanlage beeinflussen, gestellt. Insbesondere auch die Anforderungen an die Positionierung der optischen Elemente, beispielsweise der Spiegel einer EUV ("Extreme Ultra Violet") - Projektionsbelichtungsanlage, sind auflösungsbedingt mittlerweile sehr hoch. Aufgrund der geforderten hohen Genauigkeit an die optischen und mechanischen Komponenten muss auch eine Partikelkontamination bei der Herstellung, bei der Wartung und beim Betrieb einer Projektionsbelichtungsanlage berücksichtigt werden.

Zur Prüfung der Partikelbelastung einer Oberfläche sind aus der Praxis verschiedene Verfahren bekannt. Beispielsweise ist es bekannt, mittels einer Druckluftsonde in Kombination mit einem optischen Partikelzähler die Partikelbelastung einer Oberfläche zu erfassen. Ein derartiges Verfahren bietet allerdings für kleine Partikel nicht mehr die Möglichkeit einer zuverlässigen Größenbestimmung und ist daher in der Regel nicht ausreichend genau für eine zuverlässige Aussage zur Größenverteilung und zur Art der Partikel.

Weiter ist es bekannt, Partikelproben durch Beprobungsstreifen bzw. Klebepads von einer Oberfläche zu entnehmen (beispielsweise durch sogenannte "Particle Measurement Cards, PMC"), die anschließend optisch mittels Auflicht oder Streiflicht ausgewertet werden. Auch hierdurch ist allerdings keine ausreichend zuverlässige Aussage zur Größenverteilung und zur Art der Partikel möglich, da die messtechnische Erfassung mittels Auf- oder Streiflicht zu Überstrahleffekten der Partikel und damit zu einer Verfälschung des Messergebnisses führen kann.

Außerdem ist es ein Problem, dass die bekannten Verfahren eine hohe Nutzerabhängigkeit aufweisen, was in der Regel zu einer geringen Reproduzierbarkeit bei der Beprobung und Auswertung führt, beispielsweise aufgrund eines manuellen Anpressvorgangs des Beprobungsstreifens mit undefiniertem Anpressdruck.

Die bekannten Verfahren zur Beprobung einer Oberfläche zur Erfassung einer Partikelbelastung sind somit mit einer hohen Ungenauigkeit verbunden. Es besteht insbesondere ein Bedarf, die bekannten Verfahren zu verbessern, um den hohen Anforderungen bei der Partikelprüfung von Komponenten einer Projektionsbelichtungsanlage gerecht zu werden.

Zum weiteren technischen Hintergrund sei noch auf die folgenden Druckschriften verwiesen. Die US 5 068 951 A betrifft ein Partikelprüfsystem mit einem konstanten, vorgegebenen Anpressdruck zur reziproken Beprobung einer Oberfläche. Die US 7 017 397 B2 betrifft einen Probennehmer mit einer klebrigen Oberfläche. Die US 5 243 865 A betrifft einen Partikel-Kollektor mit einem Griff, einem Rahmen, Rädern und einem Rollenkörper. Die US 2002/071115 A1 betrifft einen Probennehmer aufweisend einen Rollenkörper mit einer klebrigen Oberfläche.

In Anbetracht des bekannten Stands der Technik besteht die Aufgabe der vorliegenden Erfindung darin, ein verbessertes Partikelprüfsystem bereitzustellen, mit dem insbesondere eine reduzierte Fehleranfälligkeit bei der Prüfung der Partikelbelastung einer Oberfläche gewährleistet werden kann.

Der vorliegenden Erfindung liegt auch die Aufgabe zugrunde, eine verbesserte Projektionsbelichtungsanlage für die Halbleiterlithografie mit einem Partikelprüfsystem bereitzustellen, um die Partikelbelastung von Komponenten der Projektionsbelichtungsanlage vorteilhaft überprüfen zu können, insbesondere mit reduzierter Fehleranfälligkeit.

Ferner ist es Aufgabe der Erfindung, ein verbessertes Verfahren zur Prüfung einer Partikelbelastung einer Oberfläche bereitzustellen, bei dem insbesondere die Fehleranfälligkeit reduziert ist. Schließlich liegt der Erfindung außerdem die Aufgabe zugrunde, ein vorteilhaftes Computerprogrammprodukt bereitzustellen.

Die Aufgabe wird für das Partikelprüfsystem mit den in Anspruch 1 aufgeführten Merkmalen gelöst. Hinsichtlich der Projektionsbelichtungsanlage wird die Aufgabe durch die Merkmale des Anspruchs 13 gelöst. Die Aufgabe wird schließlich für das Verfahren zur Prüfung der Partikelbelastung einer Oberfläche durch Anspruch 14 und hinsichtlich des Computerprogrammprodukts durch Anspruch 15 gelöst.

Die abhängigen Ansprüche und die nachfolgend beschriebenen Merkmale betreffen vorteilhafte Ausführungsformen und Varianten der Erfindung.

Es ist ein Partikelprüfsystem zur Prüfung der Partikelbelastung einer zu prüfenden Oberfläche vorgesehen, aufweisend einen Beprobungsstreifen zur Aufnahme von Partikeln und eine Beprobungseinrichtung.

Als Partikel im Rahmen der Erfindung können unter Anderem metallische Partikel, nicht metallische Partikel, Fasern (insbesondere Kunststofffasern), Folienstücke (einer metallischen Folie, einer nicht metallischen Folie oder einer Verbundfolie), Staubpartikel und/oder organische Partikel betrachtet werden. Im Rahmen der Erfindung können insbesondere Partikel oder Fasern aus Metallspäne, Harzen, Kunststoffen oder Staub vorteilhaft beprobt und untersucht werden.

Im Rahmen der Erfindung kann die zu prüfende Oberfläche als Teil des beanspruchten Partikelprüfsystems betrachtet werden. Die zu prüfende Oberfläche kann allerdings auch unabhängig von dem Partikelprüfsystem sein.

Bei einem Beprobungsstreifen kann es sich vorzugsweise um ein streifenförmiges Material handeln, dessen Breite sehr viel größer ist als dessen Dicke.

Vorzugsweise ist der Beprobungsstreifen aus einem Kunststoff, zum Beispiel aus einer Kunststofffolie, aus Papier, aus Metall (beispielsweise aus einer Metallfolie) und/oder aus einem Textilgewebe ausgebildet.

Erfindungsgemäß weist die Beprobungseinrichtung einen Rollenkörper auf, der eingerichtet ist, um den Beprobungsstreifen (zumindest teilweise) auf seiner Mantelfläche zu führen.

Die Erfindung ist nachfolgend exemplarisch mit einem einzigen Rollenkörper beschrieben. Grundsätzlich kann die Beprobungseinrichtung allerdings auch mehr als einen Rollenkörper aufweisen, beispielsweise zwei Rollenkörper, drei Rollenkörper, vier Rollenkörper oder noch mehr Rollenkörper mit identischem oder verschiedenem Aufbau.

Ferner können auch mehrere Beprobungsstreifen vorgesehen sein, beispielsweise zwei Beprobungsstreifen, drei Beprobungsstreifen, vier Beprobungsstreifen oder noch mehr Beprobungsstreifen mit identischem oder verschiedenem Aufbau.

Es können gegebenenfalls sogar mehrere Beprobungseinrichtungen vorgesehen sein, beispielsweise zwei Beprobungseinrichtungen, drei Beprobungseinrichtungen, vier Beprobungseinrichtungen oder noch mehr Beprobungseinrichtungen mit identischem oder verschiedenem Aufbau.

Der Beprobungsstreifen kann auf dem Rollenkörper teilweise oder vollständig aufgewickelt sein. Der Beprobungsstreifen kann in genau einer Wicklung, in weniger als einer Wicklung oder in mehr als einer Wicklung (beispielsweise in zwei, drei, vier, fünf oder noch mehr Wicklungen) auf dem Rollenkörper geführt sein.

Die Beprobungseinrichtung ist erfindungsgemäß eingerichtet, um den Rollenkörper zusammen mit dem Beprobungsstreifen auf der zu prüfenden Oberfläche abzurollen, um Partikel (bzw. Partikelproben) von der zu prüfenden Oberfläche auf den Beprobungsstreifen zu übertragen.

Der Rollenkörper kann in der Beprobungseinrichtung um eine zentrale Drehachse drehbar gelagert sein.

Der Rollenkörper kann sich durch Aufsetzen des Rollenkörpers (zusammen mit dem Beprobungsstreifen) auf der zu prüfenden Oberfläche mit einem definierten Anpressdruck und eine anschließende translatorische Bewegung der Drehachse vorzugsweise parallel zu der zu prüfenden Oberfläche auf der zu prüfenden Oberfläche abrollen derart, dass die Partikel von der Oberfläche nach und nach auf den Beprobungsstreifen übertragen werden.

Der Beprobungsstreifen kann während des Abrollens des Rollenkörpers auf dem Rollenkörper verbleiben und hierfür entsprechend an dem Rollenkörper kraftschlüssig, formschlüssig und/oder stoffschlüssig befestig sein (vorzugsweise reversibel befestigt sein). Der Beprobungsstreifen kann sich während des Abrollens des Rollenkörpers auf der zu prüfenden Oberfläche allerdings auch von dem Rollenkörper lösen und damit zunächst auf der zu prüfenden Oberfläche verbleiben. Der Beprobungsstreifen kann dadurch vollständig oder teilweise von dem Rollenkörper abgewickelt werden. Vorzugsweise verbleibt der Beprobungsstreifen allerdings auf dem Rollenkörper, während der Rollenkörper über die zu prüfende Oberfläche geführt bzw. auf der zu prüfenden Oberfläche abgerollt wird.

Erfindungsgemäß ist vorgesehen, dass die Beprobungseinrichtung eine erste Messeinrichtung und/oder eine zweite Messeinrichtung aufweist. Die erste Messeinrichtung ist ausgebildet, um eine Rotationsbewegung des Rollenkörpers zu erfassen. Die zweite Messeinrichtung ist ausgebildet, um einen Anpressdruck des Rollenkörpers auf die zu prüfende Oberfläche zu erfassen.

Vorzugsweise weist die Beprobungseinrichtung die erste Messeinrichtung und die zweite Messeinrichtung auf. Die Beprobungseinrichtung kann allerdings auch ausschließlich die erste Messeinrichtung oder die zweite Messeinrichtung aufweisen. Grundsätzlich kann die Beprobungseinrichtung auch noch weitere Messeinrichtungen aufweisen, um weitere der genannten Messungen oder sonstige Messungen durchzuführen.

Vorzugsweise sind die Messeinrichtungen eingerichtet, um die Messungen durchzuführen, während der Rollenkörper zusammen mit dem Beprobungsstreifen auf der zu prüfenden Oberfläche abgerollt wird. Die Messungen durch die Messeinrichtungen können in diskreten Zeitintervallen oder kontinuierlich durchgeführt werden. Die Messeinrichtungen, insbesondere die zweite Messeinrichtung zur Erfassung des Anpressdrucks, können die Messungen gegebenenfalls auch im Stillstand des Rollenkörpers durchführen.

Dadurch, dass die Beprobungseinrichtung die erste Messeinrichtung und/oder die zweite Messeinrichtung aufweist, kann die Beprobung der Oberfläche verbessert sein, da sich der Benutzer der Beprobungseinrichtung an den erfassten Messwerten orientieren und die Rotationsbewegung und/oder den Anpressdruck kontinuierlich an definierte Vorgaben anpassen kann. Durch die Messeinrichtungen besteht insbesondere die Möglichkeit, bei der Beprobung eine definierte Rollstrecke bzw. einen definierten Oberflächenbereich zu beproben. Ferner besteht die Möglichkeit, einen definierten Anpress- und Ablösewinkel relativ zu der zu prüfenden Oberfläche zu realisieren. Aufgrund der Messeinrichtungen können der Anpressdruck und die Abrollgeschwindigkeit während des Abrollens des Rollenkörpers auf der zu prüfenden Oberfläche vorteilhaft reproduziert und überwacht werden.

In einer vorteilhaften Weiterbildung der Erfindung kann vorgesehen sein, dass der Beprobungsstreifen eine Beprobungsfläche aufweist, die zur adhäsiven Aufnahme der Partikel von der zu prüfenden Oberfläche ausgebildet ist. Vorzugsweise ist die Beprobungsfläche von der Mantelfläche des Rollenkörpers abgewandt, wenn der Beprobungsstreifen entlang der Mantelfläche des Rollenkörpers geführt ist.

Grundsätzlich kann auch vorgesehen sein, dass der Beprobungsstreifen zwei Beprobungsflächen aufweist, die an sich gegenüberliegenden Seiten des Beprobungsstreifens verlaufen. Vorzugsweise weist der Beprobungsstreifen allerdings lediglich eine Beprobungsfläche auf.

Die der Beprobungsfläche gegenüberliegende Oberfläche des Beprobungsstreifens kann vorzugsweise ausgebildet sein, um auf der Mantelfläche des Rollenkörpers zu haften, vorzugsweise reversibel zu haften derart, dass ein Benutzer des Partikelprüfsystems den Beprobungsstreifen nach der Beprobung der Oberfläche zerstörungsfrei von dem Rollenkörper entfernen kann oder derart, dass sich der Beprobungsstreifen bereits während der Beprobung der Oberfläche von dem Rollenkörper löst.

Gemäß einer Weiterbildung der Erfindung kann vorgesehen sein, dass die Beprobungsfläche einen Haftklebstoff zur adhäsiven Aufnahme der Partikel von der zu prüfenden Oberfläche aufweist.

Der verwendete Haftklebstoff kann vorzugsweise dahingehend optimiert sein, dass einerseits die Partikel in allen zu erwartenden Arten und Größen an der Beprobungsfläche haften bleiben bzw. von der zu prüfenden Oberfläche aufgenommen werden können, wobei andererseits die Beprobungsfläche mit dem Haftklebstoff dennoch rückstandsfrei von der Oberfläche entfernt werden kann.

Vorteilhafte Hafteigenschaften der Beprobungsfläche können gegebenenfalls aber auch ohne einen Haftklebstoff bereitgestellt werden. Beispielsweise kann das Material der Beprobungsfläche (oder des gesamten Beprobungsstreifens) ausgebildet sein, dass die Partikel in die Oberfläche der Beprobungsfläche bzw. des Beprobungsstreifens eindringen und beispielsweise aufgrund von Mikroverhakungen an dem Beprobungsstreifen haften bleiben. Grundsätzlich können beliebige Haftmechanismen vorgesehen sein, um die Aufnahme der Partikel auf den Beprobungsstreifen zu ermöglichen.

Gemäß einer Weiterbildung der Erfindung kann vorgesehen sein, dass der Beprobungsstreifen aus einem lichtdurchlässigen Material ausgebildet ist. Vorzugsweise ist der Beprobungsstreifen durchsichtig.

Die Lichtdurchlässigkeit bzw. Transparenz des Beprobungsstreifens kann insbesondere orthogonal zu der Beprobungsfläche gegeben sein. Die Lichtdurchlässigkeit kann vorzugsweise dergestalt sein, dass die auf der Beprobungsfläche aufgenommenen Partikel von der der Beprobungsfläche gegenüberliegenden Seite des Beprobungsstreifens sichtbar sind.

Auf vorteilhafte Weise kann somit ein Partikelprüfsystem zur Kontaminationskontrolle von Oberflächen mittels eines transparenten Beprobungsstreifens, beispielsweise eines transparenten Klebestreifens, bereitgestellt werden. Ein Beprobungsstreifen aus einem lichtdurchlässigen Material kann sich insbesondere vorteilhaft in Kombination mit der Durchlichtmikroskopie eignen.

Die aus dem Stand der Technik bekannten Beprobungsstreifen sind hingegen aus einem lichtundurchlässigen Material ausgebildet, weshalb die Auswertung der von dem Beprobungsstreifen aufgenommenen Partikel in der Regel mittels Streiflicht (d. h. unter Verwendung einer seitlich zu der Beprobungsfläche angeordneten Lichtquelle) oder unter Verwendung von Auflicht durchgeführt wird. Hierdurch kann die Erkennbarkeit der Partikel auf der zumeist dunklen Oberfläche des Beprobungsstreifens ungenügend sein. Außerdem können Überstrahlungseffekte eine exakte Größenbestimmung der Partikel erschweren oder unmöglich machen. Dadurch, dass der Beprobungsstreifen vorliegend aus einem lichtdurchlässigen Material ausgebildet ist, kann eine Auswertung der auf dem Beprobungsstreifen befindlichen Partikel unter Verwendung von Durchlicht erfolgen. Die Fehleranfälligkeit insbesondere bei der Größenbestimmung der Partikel, kann dadurch verringert sein.

Erfindungsgemäß ist vorgesehen, dass der Rollenkörper in der Beprobungseinrichtung relativ zu der zu prüfenden Oberfläche elastisch gelagert, vorzugsweise federgelagert, ist. Vorzugsweise ist der Rollenkörper mittels einem oder mehreren elastischen Elementen in der Beprobungseinrichtung gelagert.

Dadurch, dass der Rollenkörper in der Beprobungseinrichtung durch eines oder mehrere elastische Elemente gelagert ist, kann vorteilhaft ein definierter Anpressdruck des Rollenkörpers auf die zu prüfende Oberfläche einstellbar sein. Dies kann beispielsweise durch eine Gewichtskomponente der Beprobungseinrichtung oder des Rollenkörpers, die auf die elastischen Elemente bzw. auf die Federn wirkt, einen Abstand der Beprobungseinrichtung von der zu prüfenden Oberfläche und/oder durch eine Einstellbarkeit der Elastizität (oder eine sonstige Beeinflussung) der elastischen Elemente erfolgen.

Der Anpressdruck kann vorteilhaft für verschiedene zu beprobende bzw. zu untersuchende Oberflächen optimiert werden. Beispielsweise kann vorgesehen sein, den Anpressdruck auf eine Metalloberfläche, beispielsweise eine Edelstahloberfläche, höher auszulegen als auf eine Kunststoffoberfläche.

Der optimale Anpressdruck kann anhand von Simulationen oder Versuchsreihen für die jeweilige Oberflächenart ermittelt werden, um die von dem Beprobungsstreifen aufgenommene Partikelmenge zu maximieren.

Vorzugsweise ist der Rollenkörper über eine oder mehrere, beispielsweise zwei, drei, vier oder noch mehr elastische Elemente, beispielsweise Federn (u. a. lineare Federn, wie Kegelfedern oder Druckfedern) oder elastische Polymere, mit einer Rahmenbaugruppe der Beprobungseinrichtung verbunden.

In einer Weiterbildung der Erfindung kann vorgesehen sein, dass die erste Messeinrichtung einen optischen Sensor oder einen magnetischen Sensor aufweist, um den Drehwinkel des Rollenkörpers, die Umdrehungszahl des Rollenkörpers und/oder die Winkelgeschwindigkeit des Rollenkörpers zu erfassen.

Die erste Messeinrichtung kann ausgebildet sein, um eine dynamische Bewegung des Rollenkörpers zu erfassen.

Beispielsweise kann ein optischer Sensor der ersten Messeinrichtung ausgebildet sein, um eine oder mehrere optische Marker entlang des Umfangs des Rollenkörpers zu erfassen, um hieraus eine Winkeländerung des Rollenkörpers zu bestimmen, die wiederum zur Erfassung der Umdrehungszahl und/oder Winkelgeschwindigkeit des Rollenkörpers herangezogen werden kann.

Alternativ oder zusätzlich kann die erste Messeinrichtung auch einen magnetischen Sensor aufweisen, beispielsweise einen oder mehrere Reed-Sensoren.

Grundsätzlich kann die erste Messeinrichtung alternativ oder zusätzlich auch noch beliebige weitere Sensorarten zur Erfassung der dynamischen Bewegung bzw. der Abrollbewegung des Rollenkörpers auf der zu prüfenden Oberfläche aufweisen. Die Verwendung eines optischen Sensors und/oder eines magnetischen Sensors ist lediglich beispielhaft genannt.

In einer vorteilhaften Weiterbildung der Erfindung kann vorgesehen sein, dass die zweite Messeinrichtung einen Kraftaufnehmer aufweist, vorzugsweise einen Federkörper-Kraftaufnehmer, einen elektrodynamischen Kraftaufnehmer oder einen Piezo-Kraftaufnehmer, um den Anpressdruck des Rollenkörpers auf die zu prüfende Oberfläche zu erfassen.

Beispielsweise kann ein Kraftaufnehmer oder ein sonstiger Sensor der zweiten Messeinrichtung ausgebildet sein, um die Dehnung bzw. Auslenkung einer linearen Feder oder eines elastischen Polymers zu erfassen, die den Rollenkörper mit einer Rahmenbaugruppe der Beprobungseinrichtung elastisch verbindet. Durch einen Abgleich mit einem Referenzelement kann somit anhand der Auslenkung der Feder oder des elastischen Polymers auf den Anpressdruck geschlossen werden.

Sofern der Rollenkörper an mehreren Stellen elastisch mit der Rahmenbaugruppe der Beprobungseinrichtung verbunden ist, beispielsweise durch Verwendung mehrerer Federn oder mehrerer elastischer Polymere, können optional auch mehrere zweite Messeinrichtungen oder mehrere Kraftaufnehmer einer gemeinsamen zweiten Messeinrichtung vorgesehen sein, um den Anpressdruck des Rollenkörpers gemeinsam zu erfassen.

Die vorstehend genannten technischen Realisierungsprinzipien zur Ausbildung des Kraftaufnehmers sind lediglich beispielhaft zu verstehen. Grundsätzlich kann die zweite Messeinrichtung auf beliebige Art und Weise ausgebildet sein, um den Anpressdruck des Rollenkörpers auf die zu prüfende Oberfläche zu erfassen.

In einer Weiterbildung der Erfindung kann vorgesehen sein, dass die Beprobungseinrichtung eine Anzeige, insbesondere eine elektronische Anzeige, aufweist, um die mittels der ersten Messeinrichtung und/oder die mittels der zweiten Messeinrichtung erfassten Informationen einem Benutzer der Beprobungseinrichtung anzuzeigen.

Über die Anzeige kann dem Benutzer somit vorteilhaft aufgezeigt werden, ob der Anpressdruck und die Rotationsbewegung des Rollenkörpers den Vorgaben entspricht. Der Benutzer kann unter Berücksichtigung der angezeigten Daten somit den Anpressdruck optimieren und/oder die Rotationsbewegung des Rollenkörpers, beispielsweise die Geschwindigkeit des Rollenkörpers, optimieren.

Die Rotationsbewegung des Rollenkörpers, beispielsweise die Winkelgeschwindigkeit, mit der der Rollenkörper auf der Oberfläche abrollt, kann optimiert werden, um die von dem Beprobungsstreifen aufgenommene Partikelmenge zu maximieren und/oder die Beprobungsdauer zu minimieren.

Alternativ oder zusätzlich zur Verwendung einer Anzeige kann auch vorgesehen sein, dass die Beprobungseinrichtung aktorische oder mechanische Mittel aufweist, um (vorzugsweise aber nicht notwendigerweise in Abhängigkeit der mittels der ersten Messeinrichtung und/oder der mittels der zweiten Messeinrichtung erfassten Informationen) den Anpressdruck und/oder die Geschwindigkeit oder Umdrehungszahl des Rollenkörpers zu limitieren.

Erfindungsgemäß ist vorgesehen, dass die Beprobungseinrichtung einen Führungsrahmen aufweist, um die Beprobungseinrichtung auf der zu prüfenden Oberfläche oder neben der zu prüfenden Oberfläche aufzusetzen. Der Führungsrahmen weist wenigstens ein Aufsetzinterface auf, mit dem der Führungsrahmen auf der zu prüfenden Oberfläche oder auf einer sonstigen Oberfläche (neben der zu prüfenden Oberfläche) aufliegt.

Der Führungsrahmen kann einen, zwei, drei, vier oder noch mehr Schenkel aufweisen, um die Beprobungseinrichtung auf der zu prüfenden Oberfläche oder neben der zu prüfenden Oberfläche aufzusetzen. Besonders bevorzugt weist der Führungsrahmen vier Schenkel bzw. vier Aufsetzpunkte auf.

Durch die Verwendung eines Führungsrahmens kann der Abstand der Beprobungseinrichtung zu der zu prüfenden Oberfläche und damit auch der Abstand des Rollenkörpers zu der zu prüfenden Oberfläche sowie dessen Anpressdruck definiert vorgegeben werden. Hierdurch kann insbesondere der Anpressdruck von dem Benutzer entkoppelt werden und die Beprobung damit zu besonders reproduzierbaren Ergebnissen führen.

Optional kann vorgesehen sein, dass der Abstand der Beprobungseinrichtung bzw. des Rollenkörpers von der zu prüfenden Oberfläche durch den Führungsrahmen einstellbar ist, beispielsweise unter Verwendung einer Stellschraube oder eines Teleskopauszugs.

In einer vorteilhaften Weiterbildung der Erfindung kann vorgesehen sein, dass der Führungsrahmen auf der zu prüfenden Oberfläche oder neben der zu prüfenden Oberfläche parallel zu der zu prüfenden Oberfläche verschiebbar ist, um den Rollenkörper zusammen mit dem Beprobungsstreifen auf der zu prüfenden Oberfläche abzurollen.

Beispielsweise kann der Führungsrahmen Rollen oder Räder aufweisen, um eine besonders reibungsarme und schonende Verschiebbarkeit auf der zu prüfenden Oberfläche oder neben der zu prüfenden Oberfläche zu gewährleisten.

Die Rollen bzw. Räder des Führungsrahmens oder ein sonstiges Aufsetzinterface, mit dem der Führungsrahmen auf der zu prüfenden Oberfläche oder auf einer sonstigen Oberfläche aufliegt, können vorzugsweise aus einem Kunststoff oder aus einem Gummi ausgebildet sein, um die zu prüfende Oberfläche mechanisch zu schonen und um möglichst keine Rückstände oder Partikel auf der Oberfläche zu hinterlassen.

In einer vorteilhaften Weiterbildung der Erfindung kann vorgesehen sein, dass die Beprobungseinrichtung eine Aktuatoreinrichtung aufweist, um den Rollenkörper parallel zu der zu prüfenden Oberfläche zu verschieben, um den Rollenkörper zusammen mit dem Beprobungsstreifen automatisiert auf der zu prüfenden Oberfläche abzurollen.

Vorzugsweise kann eine lineare Aktuatoreinrichtung bzw. ein Linearaktuator vorgesehen sein. Beispielsweise kann der Rollenkörper über eine in einer Schiene der Beprobungseinrichtung geführte Translatoreinheit verschiebbar sein, beispielsweise unter Verwendung eines Seilzugs, der an der Translatoreinheit angreift.

In einer Weiterbildung der Erfindung kann vorgesehen sein, dass das Partikelprüfsystem eine Auswertungseinrichtung aufweist die ausgebildet ist, um die von dem Beprobungsstreifen aufgenommenen Partikel nach Partikelgröße, Partikelart, Partikelmenge und/oder Partikelverteilung auszuwerten.

Das Auswertungsergebnis betreffend die Partikel kann von der Auswertungseinrichtung optional mit Messwerten der Beprobung kombiniert werden, beispielsweise mit Informationen zu dem verwendeten Anpressdruck, zu der Größe des untersuchten Oberflächenabschnitts und/oder zu der Rotationsgeschwindigkeit des Rollenkörpers.

Vorzugsweise ist eine automatisierte Auswertung unter Verwendung einer Steuereinrichtung vorgesehen, insbesondere mittels einer Bild-Auswertungssoftware.

Die Auswertungseinrichtung kann teilweise oder vollständig in die Beprobungseinrichtung integriert sein. Vorzugsweise ist die Auswertungseinrichtung allerdings von der Beprobungseinrichtung separat ausgebildet. Hierdurch können Gewicht und Abmessung der Beprobungseinrichtung vorteilhaft reduziert sein.

Der Beprobungsstreifen kann von dem Benutzer des Partikelprüfsystems nach der Beprobung bzw. nach der Aufnahme der Partikel von dem Rollenkörper und/oder von der zu prüfenden Oberfläche abgenommen und zur Auswertung der Auswertungseinrichtung zugeführt werden. Zur leichteren Entnahme des Beprobungsstreifens kann optional auch der gesamte Rollenkörper aus der Beprobungseinrichtung entnehmbar sein.

Die Auswertungseinrichtung kann eingerichtet sein, um das Ergebnis der Auswertung dem Benutzer anzuzeigen, beispielsweise anhand einer Anzeige oder eines Ausdrucks. Die Auswertungseinrichtung kann ergänzend oder alternativ auch eingerichtet sein, um das Ergebnis der Auswertung zu dokumentieren, beispielsweise auf einem Datenspeicher zu dokumentieren und optional mit einem Identifikator für die geprüfte Oberfläche oder für das geprüft Objekt / die geprüfte Komponente zu verknüpfen.

Gemäß einer Weiterbildung der Erfindung kann vorgesehen sein, dass die Auswertungseinrichtung ein Lichtmikroskop umfasst, vorzugsweise ein Durchlichtmikroskop.

Somit kann auf vorteilhafte Weise eine mikroskopische Untersuchung des Beprobungsstreifens erfolgen. Besonders bevorzugt kann ein Durchlichtmikroskop verwendet werden, insbesondere wenn der Beprobungsstreifen lichtdurchlässig ist. Alternativ kann allerdings auch eine (optische) Untersuchung, vorzugsweise eine mikroskopische Untersuchung, unter Verwendung von Streiflicht oder Auflicht vorgesehen sein, insbesondere wenn der Beprobungsstreifen nicht transparent ist.

Die Erfindung betrifft auch eine Projektionsbelichtungsanlage für die Halbleiterlithographie, wobei ein Partikelprüfsystem (insbesondere - aber nicht ausschließlich - gemäß den vorstehenden und nachfolgenden Ausführungen) zur Prüfung einer Partikelbelastung einer Oberfläche einer Komponente der Projektionsbelichtungsanlage vorgesehen ist.

Die Projektionsbelichtungsanlage bzw. deren Komponenten / Bauteile können aufgrund des Partikelprüfsystems vorteilhaft auf Sauberkeit überprüft werden, insbesondere während des Herstellungsprozesses.

Die Prüfung kann vorzugsweise für eine Oberfläche eines optischen Elements einer Optik der Projektionsbelichtungsanlage durchgeführt werden. Bei dem optischen Element kann es sich insbesondere um eine Linse oder um einen Spiegel handeln.

Grundsätzlich kann die Prüfung allerding für eine beliebige Komponente der Projektionsbelichtungsanlage durchgeführt werden, beispielsweise auch für eine rein mechanische Komponente, für eine Komponente einer Lichtquelle der Projektionsbelichtungsanlage oder für den Wafer der Projektionsbelichtungsanlage.

Die Prüfung der Partikelbelastung eignet sich besonders vorteilhaft für Komponenten, die im Rahmen der Montage der Projektionsbelichtungsanlage mit anderen Komponenten zusammengefügt werden bzw. die an anderen Komponenten montiert werden oder für Komponenten, die von einer Gehäusekomponente umgeben werden.

Die Partikelprüfung kann vorteilhaft während der Herstellung und/oder während der Montage der Projektionsbelichtungsanlage erfolgen, beispielsweise bevor die zu beprobenden bzw. zu untersuchenden Komponenten zusammengefügt werden. Die Partikelprüfung kann allerdings auch während des Betriebs der Anlage, beispielsweise während Wartungsintervallen, regelmäßig durchgeführt werden, um den ordnungsgemäßen Betrieb der Projektionsbelichtungsanlage langfristig zu gewährleisten.

Die Erfindung eignet sich insbesondere zur Verwendung mit einer mikrolithografischen DUV ("Deep Ultra Violet") - Projektionsbelichtungsanlage und ganz besonders zur Verwendung mit einer mikrolithografischen EUV-Projektionsbelichtungsanlage. Eine mögliche Verwendung der Erfindung betrifft auch die Immersionslithographie. Die Partikelbeprobung einer Projektionsbelichtungsanlage ist dabei allerdings nur ein beispielhafter Anwendungsfall für die Erfindung.

Der Beprobungsstreifen kann ausgebildet sein, um auf einer Mantelfläche eines Rollenkörpers montierbar zu sein.

Gemäß einer Ausgestaltung des Beprobungsstreifens kann vorgesehen sein, dass die Beprobungsfläche einen Haftklebstoff zur adhäsiven Aufnahme von Partikeln von der zu prüfenden Oberfläche aufweist.

Es kann vorgesehen sein, dass der Beprobungsstreifen orthogonal zu der Beprobungsfläche eine ausreichende Elastizität aufweist, um alle Arten zu erwartender Partikel und alle Größen zu erwartender Partikel aufnehmen zu können. Die Deformierbarkeit bzw. die Elastizität des Beprobungsstreifens kann derart gewählt sein, dass sich die Partikel bei dem vorgesehenen Anpressdruck ausreichend tief in die Beprobungsfläche eindrücken lassen, so dass die Beprobungsfläche eine ausreichende Haltekraft für die Partikel bereitstellt kann.

Die Dicke des Beprobungsstreifens, d. h. seine Erstreckung von der Beprobungsfläche zu der der Beprobungsfläche gegenüberliegenden Seite, kann beispielsweise 0,50 mm bis 5,00 mm, vorzugsweise 0,75 mm bis 3,00 mm, besonders bevorzugt 1,00 mm bis 2,00 mm betragen. Grundsätzlich kann die Dicke auch kleiner sein als 0,50 mm oder größer sein als 5,00 mm.

Der erfindungsgemäße Beprobungsstreifen kann sich insbesondere zur Prüfung der Partikelbelastung von Oberflächen von Komponenten einer Projektionsbelichtungsanlage für die Halbleiterlithografie vorteilhaft eignen.

Der Beprobungsstreifen kann auf vorteilhafte Weise zur Kontaminationskontrolle bzw. zur Partikelinspektion verwendet werden, wobei gerade die Kombination eines lichtdurchlässigen Beprobungsstreifens mit der Durchlichtmikroskopie besonders exakte und reproduzierbare Ergebnisse liefern kann.

Das Ergebnis der Beprobung kann schließlich dazu verwendet werden, im Rahmen der technischen Sauberkeit eine Reinigung der beprobten Oberfläche bzw. der beprobten Komponente zu bestimmen, wenn die Partikelkontamination einen definierten Schwellenwert überschreitet.

Die Erfindung betrifft ferner ein Verfahren zur Prüfung einer Partikelbelastung einer Oberfläche, wonach ein Rollenkörper einer Beprobungseinrichtung zusammen mit einem auf einer Mantelfläche des Rollenkörpers geführten Beprobungsstreifen auf der zu prüfenden Oberfläche abgerollt wird, um die Partikel von der zu prüfenden Oberfläche auf den Beprobungsstreifen zu übertragen.

Es ist eine erste Messeinrichtung vorgesehen, die eine Rotationsbewegung des Rollenkörpers umfasst. Alternativ oder zusätzlich zu der ersten Messeinrichtung ist eine zweite Messeinrichtung vorgesehen, die einen Anpressdruck des Rollenkörpers auf die zu prüfende Oberfläche erfasst.

Durch das erfindungsgemäße Verfahren kann auf vorteilhafte Weise die Reproduzierbarkeit und Genauigkeit bei der Partikelinspektion, insbesondere bei der Probenentnahme der Partikel von der zu prüfenden Oberfläche, verbessert sein, da die Nutzerabhängigkeit zumindest reduziert sein kann.

Der Anpressvorgang kann messtechnisch und/oder aktorisch unterstützt oder vollständig automatisiert durchgeführt werden. Das Abrollen des Rollenkörpers auf der zu prüfenden Oberfläche kann messtechnisch und/oder aktorisch unterstützt oder vollständig automatisiert sein.

In einer vorteilhaften Ausgestaltung des Verfahrens kann vorgesehen sein, dass der Beprobungsstreifen derart auf der Mantelfläche geführt wird, dass eine Beprobungsfläche des Beprobungsstreifens, die zur adhäsiven Aufnahme der Partikel von der zu prüfenden Oberfläche ausgebildet ist, von der Mantelfläche des Rollenkörpers abgewandt verläuft.

In einer vorteilhaften Ausgestaltung des Verfahrens kann außerdem vorgesehen sein, die Beprobungsfläche mit einem Haftklebstoff zur adhäsiven Aufnahme der Partikel zu versehen.

Gemäß einer Ausgestaltung des Verfahrens kann ferner vorgesehen sein, dass der Beprobungsstreifen aus einem lichtdurchlässigen Material ausgebildet wird.

In einer vorteilhaften Ausgestaltung des Verfahrens kann vorgesehen sein, dass der Rollenkörper in der Beprobungseinrichtung relativ zu der zu prüfenden Oberfläche elastisch gelagert, vorzugsweise federgelagert, wird.

In einer vorteilhaften Ausgestaltung des Verfahrens kann vorgesehen sein, dass die die mittels der ersten Messeinrichtung und/oder die mittels der zweiten Messeinrichtung erfassten Informationen einem Benutzer der Beprobungseinrichtung angezeigt werden.

Erfindungsgemäß ist im Rahmen des Verfahrens vorgesehen, dass die Beprobungseinrichtung über einen Führungsrahmen auf der zu prüfenden Oberfläche oder neben der zu prüfenden Oberfläche aufgesetzt wird. Der Führungsrahmen weist wenigstens ein Aufsetzinterface auf, mit dem der Führungsrahmen auf der zu prüfenden Oberfläche oder auf einer sonstigen Oberfläche aufliegt. Der Rollenkörper wird in der Beprobungseinrichtung außerdem relativ zu der zu prüfenden Oberfläche elastisch gelagert.

Gemäß einer Ausgestaltung des Verfahrens kann vorgesehen sein, dass der Führungsrahmen auf der zu prüfenden Oberfläche oder neben der zu prüfenden Oberfläche parallel zu der zu prüfenden Oberfläche verschoben wird, um den Rollenkörper zusammen mit dem Beprobungsstreifen auf der zu prüfenden Oberfläche abzurollen.

In einer vorteilhaften Ausgestaltung des Verfahrens kann vorgesehen sein, dass der Rollenkörper von einer Aktuatoreinrichtung parallel zu der zu prüfenden Oberfläche verschoben wird, um den Rollenkörper zusammen mit dem Beprobungsstreifen automatisiert auf der zu prüfenden Oberfläche abzurollen.

In einer Ausgestaltung des Verfahrens kann vorgesehen sein, dass die von dem Beprobungsstreifen aufgenommenen Partikel nach Partikelgröße, Partikelart, Partikelmenge und/oder Partikelverteilung ausgewertet werden.

Gemäß einer Ausgestaltung des Verfahrens kann vorgesehen sein, dass die Auswertung durch eine mikroskopische Untersuchung, vorzugsweise unter Verwendung von Durchlicht, durchgeführt wird.

Die Erfindung betrifft schließlich auch ein Computerprogrammprodukt mit Programmcodemitteln, um ein Verfahren gemäß den vorstehenden und nachfolgenden Ausführungen durchzuführen, wenn das Programm auf einer Steuereinrichtung eines Partikelprüfsystems (insbesondere - aber nicht ausschließlich - auf einer Steuereinrichtung eines Partikelprüfsystems gemäß den vorstehenden und nachfolgenden Ausführungen) ausgeführt wird.

Die Steuereinrichtung kann als Mikroprozessor ausgebildet sein. Anstelle eines Mikroprozessors kann auch eine beliebige weitere Einrichtung zur Implementierung der Steuereinrichtung vorgesehen sein, beispielsweise eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Merkmale, die im Zusammenhang mit dem erfindungsgemäßen Partikelprüfsystem beschrieben wurden, sind selbstverständlich auch für die erfindungsgemäße Projektionsbelichtungsanlage, den erfindungsgemäßen Beprobungsstreifen, die erfindungsgemäße Verwendung, das erfindungsgemäße Verfahren und das erfindungsgemäße Computerprogrammprodukt vorteilhaft umsetzbar - und umgekehrt. Ferner können Vorteile, die im Zusammenhang mit dem erfindungsgemäßen Partikelprüfsystem genannt wurden, auch auf die erfindungsgemäße Projektionsbelichtungsanlage, den erfindungsgemäßen Beprobungsstreifen, die erfindungsgemäße Verwendung, das erfindungsgemäße Verfahren und das erfindungsgemäße Computerprogrammprodukt bezogen verstanden werden - und umgekehrt.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielswiese ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind.

In den Figuren sind funktionsgleiche Elemente mit denselben Bezugszeichen versehen. Es zeigen schematisch:
- Figur 1: eine EUV-Projektionsbelichtungsanlage;
- Figur 2: eine DUV-Projektionsbelichtungsanlage;
- Figur 3: eine immersionslithographische Projektionsbelichtungsanlage;
- Figur 4: ein erfindungsgemäßes Partikelprüfsystem mit einer Beprobungseinrichtung, einem Beprobungsstreifen und einer Auswertungseinrichtung;
- Figur 5: die Beprobungseinrichtung der Figur 4 in einer vergrößerten Einzeldarstellung;
- Figur 6: ein zweites Ausführungsbeispiel einer Beprobungseinrichtung mit einem parallel zu der zu prüfenden Oberfläche verschiebbaren Führungsrahmen;
- Figur 7: ein drittes Ausführungsbeispiel einer Beprobungseinrichtung mit einer Aktuatoreinrichtung zur automatisierten Verschiebung des Rollenkörpers parallel zu der zu prüfenden Oberfläche;
- Figur 8: ein viertes Ausführungsbeispiel einer Beprobungseinrichtung mit einer in die Beprobungseinrichtung integrierten Auswertungseinrichtung; und
- Figur 9: die Abrollbewegung des Rollenkörpers und des Beprobungsstreifens in einer vergrößerten Einzeldarstellung.

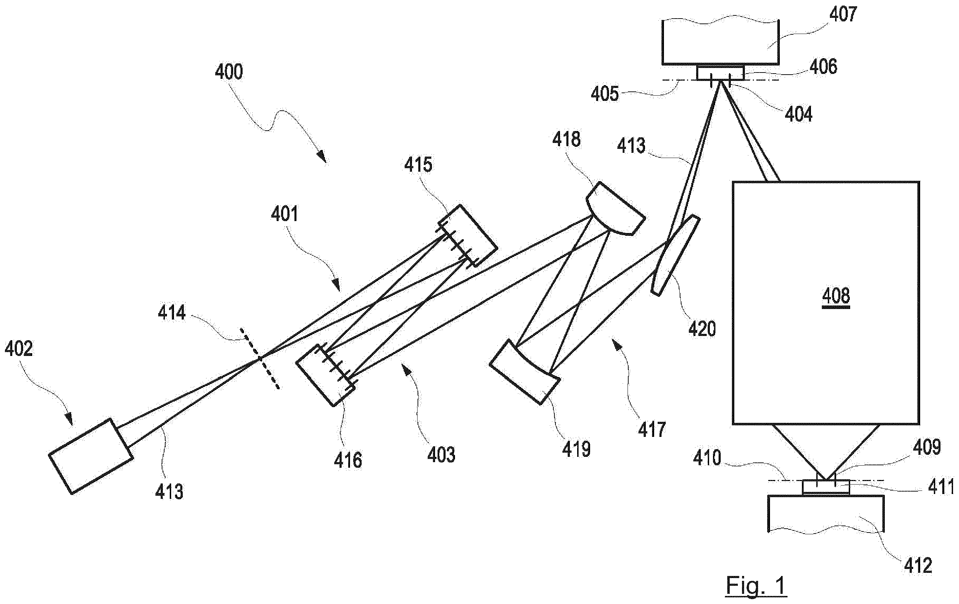

Figur 1 zeigt exemplarisch den prinzipiellen Aufbau einer EUV-Projektionsbelichtungsanlage 400 für die Halbleiterlithographie, für die die Erfindung Anwendung finden kann. Ein Beleuchtungssystem 401 der Projektionsbelichtungsanlage 400 weist neben einer Strahlungsquelle 402 eine Optik 403 zur Beleuchtung eines Objektfeldes 404 in einer Objektebene 405 auf. Beleuchtet wird ein im Objektfeld 404 angeordnetes Retikel 406, das von einem schematisch dargestellten Retikelhalter 407 gehalten ist. Eine lediglich schematisch dargestellte Projektionsoptik 408 dient zur Abbildung des Objektfeldes 404 in ein Bildfeld 409 in einer Bildebene 410. Abgebildet wird eine Struktur auf dem Retikel 406 auf eine lichtempfindliche Schicht eines im Bereich des Bildfeldes 409 in der Bildebene 410 angeordneten Wafers 411, der von einem ebenfalls ausschnittsweise dargestellten Waferhalter 412 gehalten ist.

Die Strahlungsquelle 402 kann EUV-Strahlung 413, insbesondere im Bereich zwischen 5 Nanometer und 30 Nanometer, emittieren. Zur Steuerung des Strahlungswegs der EUV-Strahlung 413 werden optisch verschieden ausgebildete und mechanisch verstellbare optische Elemente 415, 416, 418, 419, 420 eingesetzt. Die optischen Elemente sind bei der in Figur 1 dargestellten EUV-Projektionsbelichtungsanlage 400 als verstellbare Spiegel in geeigneten und nachfolgend nur beispielhaft erwähnten Ausführungsformen ausgebildet.

Die mit der Strahlungsquelle 402 erzeugte EUV-Strahlung 413 wird mittels eines in der Strahlungsquelle 402 integrierten Kollektors derart ausgerichtet, dass die EUV-Strahlung 413 im Bereich einer Zwischenfokusebene 414 einen Zwischenfokus durchläuft, bevor die EUV-Strahlung 413 auf einen Feldfacettenspiegel 415 trifft. Nach dem Feldfacettenspiegel 415 wird die EUV-Strahlung 413 von einem Pupillenfacettenspiegel 416 reflektiert. Unter Zuhilfenahme des Pupillenfacettenspiegels 416 und einer optischen Baugruppe 417 mit Spiegeln 418, 419, 420 werden Feldfacetten des Feldfacettenspiegels 415 in das Objektfeld 404 abgebildet.

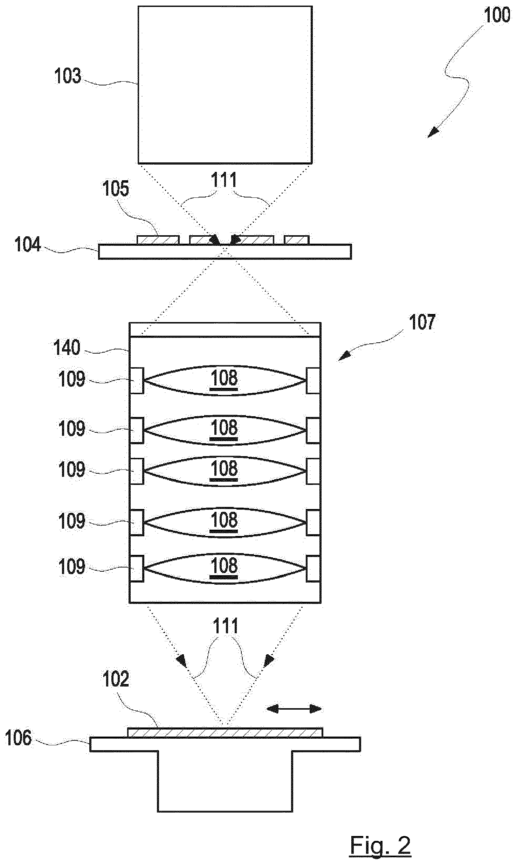

In Figur 2 ist eine beispielhafte DUV-Projektionsbelichtungsanlage 100 dargestellt. Die Projektionsbelichtungsanlage 100 weist ein Beleuchtungssystem 103, eine Retikelstage 104 genannten Einrichtung zur Aufnahme und exakten Positionierung eines Retikels 105, durch welches die späteren Strukturen auf einem Wafer 102 bestimmt werden, einen Waferhalter 106 zur Halterung, Bewegung und exakten Positionierung des Wafers 102 und eine Abbildungseinrichtung, nämlich ein Projektionsobjektiv 107, mit mehreren optischen Elementen 108, die über Fassungen 109 in einem Objektivgehäuse 140 des Projektionsobjektivs 107 gehalten sind, auf.

Die optischen Elemente 108 können als einzelne refraktive, diffraktive und/oder reflexive optische Elemente 108, wie z. B. Linsen, Spiegel, Prismen, Abschlussplatten und dergleichen, ausgebildet sein.

Das grundsätzliche Funktionsprinzip der Projektionsbelichtungsanlage 100 sieht vor, dass die in das Retikel 105 eingebrachten Strukturen auf den Wafer 102 abgebildet werden.

Das Beleuchtungssystem 103 stellt einen für die Abbildung des Retikels 105 auf den Wafer 102 benötigten Projektionsstrahl 111 in Form elektromagnetischer Strahlung bereit. Als Quelle für diese Strahlung kann ein Laser, eine Plasmaquelle oder dergleichen Verwendung finden. Die Strahlung wird in dem Beleuchtungssystem 103 über optische Elemente so geformt, dass der Projektionsstrahl 111 beim Auftreffen auf das Retikel 105 die gewünschten Eigenschaften hinsichtlich Durchmesser, Polarisation, Form der Wellenfront und dergleichen aufweist.

Mittels des Projektionsstrahls 111 wird ein Bild des Retikels 105 erzeugt und von dem Projektionsobjektiv 107 entsprechend verkleinert auf den Wafer 102 übertragen. Dabei können das Retikel 105 und der Wafer 102 synchron verfahren werden, so dass praktisch kontinuierlich während eines sogenannten Scanvorganges Bereiche des Retikels 105 auf entsprechende Bereiche des Wafers 102 abgebildet werden.

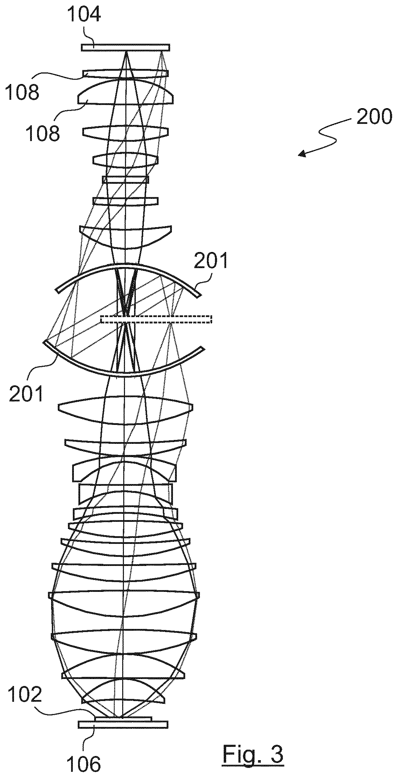

In Figur 3 ist eine dritte Projektionsbelichtungsanlage 200 in Ausbildung als immersionslithographische DUV-Projektionsbelichtungsanlage beispielhaft dargestellt. Zum weiteren Hintergrund einer derartigen Projektionsbelichtungsanlage 200 wird beispielsweise auf die WO 2005/069055 A2 verwiesen.

Erkennbar ist, vergleichbar mit der DUV-Projektionsbelichtungsanlage 100 gemäß Figur 2, eine Retikelstage 104, durch welche die späteren Strukturen auf dem Wafer 102, der auf dem Waferhalter 106 bzw. Wafertisch angeordnet ist, bestimmt werden. Die Projektionsbelichtungsanlage 200 der Figur 3 weist hierzu ebenfalls mehrere optische Elemente, insbesondere Linsen 108 und Spiegel 201, auf.

Die Verwendung der Erfindung ist nicht auf den Einsatz in Projektionsbelichtungsanlagen 100, 200, 400 beschränkt, insbesondere nicht auf Projektionsbelichtungsanlagen 100, 200, 400 mit dem beschriebenen Aufbau. Die erfindungsgemäße Messanordnung, und das erfindungsgemäße Messverfahren eignen sich grundsätzlich zur Ermittlung der Ausrichtung bzw. Position und/oder Orientierung beliebiger optischer Elemente.

Die nachfolgenden Figuren stellen die Erfindung lediglich beispielhaft und stark schematisiert dar.

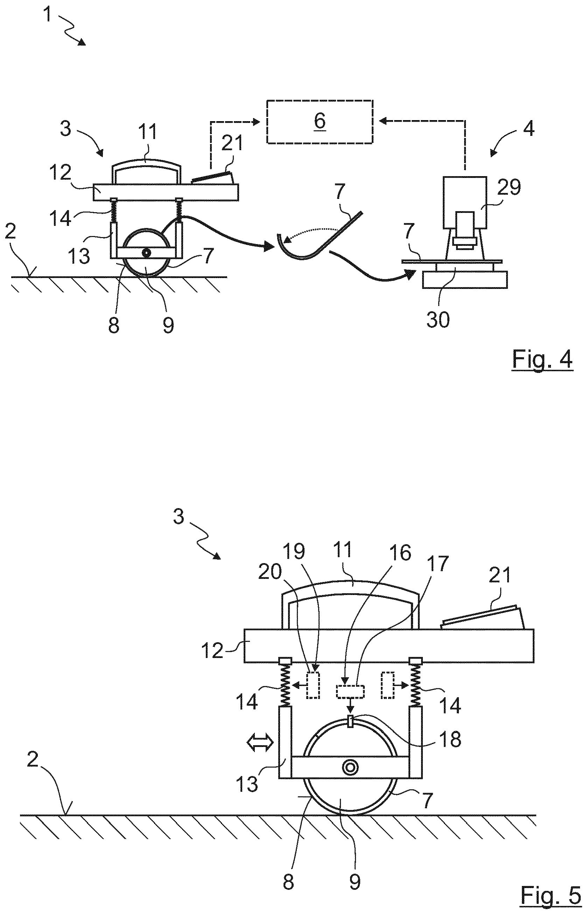

Figur 4 zeigt ein erfindungsgemäßes Partikelprüfsystem 1 zur Prüfung einer Partikelbelastung einer Oberfläche 2. Grundsätzlich kann das Partikelprüfsystem 1 zur Prüfung der Partikelbelastung einer beliebigen Oberfläche 2 einer beliebigen Komponente verwendbar sein. Besonders vorteilhaft kann allerdings die Partikelbelastung einer Oberfläche 2 einer Komponente einer Projektionsbelichtungsanlage, beispielsweise einer der vorstehend beschriebenen Projektionsbelichtungsanlagen 100, 200, 400 durchgeführt werden. Ganz besonders bevorzugt kann das Partikelprüfsystem 1 zur Prüfung einer Oberfläche 2 eines optischen Elements, beispielsweise eines der vorstehend beschriebenen optischen Elemente 415, 416, 418, 419, 420, 108, 201 einer Optik 107, 403, 408 der Projektionsbelichtungsanlage 100, 200, 400 verwendet werden. Insbesondere kann sich das Partikelprüfsystem 1 aber auch zur Untersuchung der Partikelbelastung einer Oberfläche 2 einer mechanischen Komponente / eines mechanischen Bauteils einer Projektionsbelichtungsanlage, beispielsweise einer der vorstehend beschriebenen Projektionsbelichtungsanlagen 100, 200, 400, eignen. Die Erfindung eignet sich natürlich auch zur Prüfung der Partikelbelastung von Oberflächen 2 von Projektionsbelichtungsanlagen mit anderen als den beschriebenen Designs.

Die Erfindung eignet sich grundsätzlich zur Prüfung der Partikelbelastung von beliebigen Oberflächen 2, die auf Partikelsauberkeit qualifiziert werden müssen.

Das Partikelprüfsystem 1 weist eine Beprobungseinrichtung 3 zur Beprobung der zu prüfenden Oberfläche 2 auf. Figur 5 zeigt eine vergrößerte Darstellung der Beprobungseinrichtung der Figur 4.

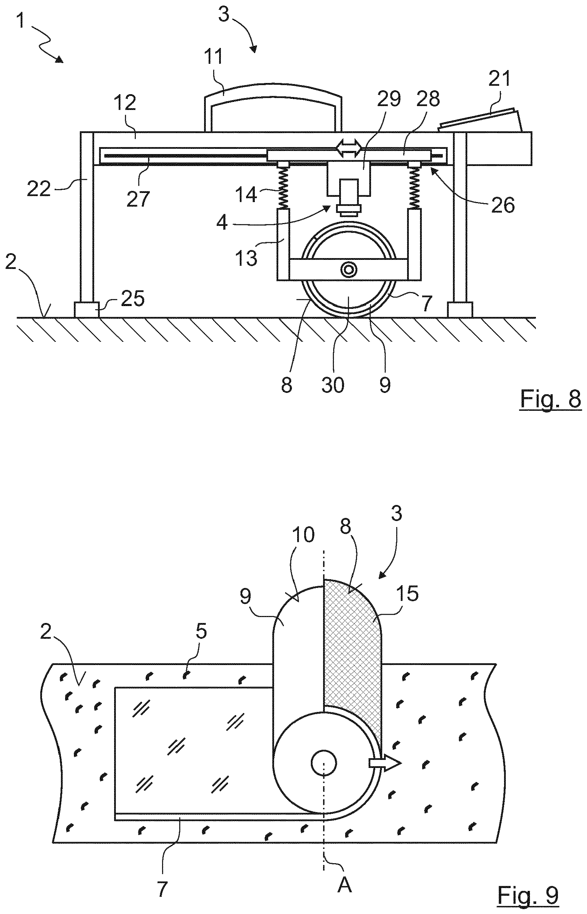

Das Partikelprüfsystem 1 weist außerdem eine Auswertungseinrichtung 4 auf, die ausgebildet ist, um die von der Beprobungseinrichtung 3 aufgenommenen Partikel 5 (vgl. Figur 9) nach Partikelgröße, Partikelart, Partikelmenge und/oder Partikelverteilung auszuwerten. Eine Steuereinrichtung 6 kann zur Überwachung und/oder Auswertung und/oder Steuerung der Partikelprüfung (Beprobung und/oder Auswertung) vorgesehen sein. Insbesondere kann ein Computerprogrammprodukt mit Programmcodemitteln vorgesehen sein, um ein Verfahren zur Prüfung der Partikelbelastung der zu prüfenden Oberfläche 2 zu betreiben, wenn das Programm auf der Steuereinrichtung 6 des Partikelprüfsystems 1 ausgeführt wird.

Das Partikelprüfsystem 1 weist außerdem einen Beprobungsstreifen 7 zur Aufnahme von Partikeln 5 von der zu prüfenden Oberfläche 2 auf. Der Beprobungsstreifen 7 kann insbesondere zur adhäsiven Aufnahme der Partikel 5 ausgebildet sein und hierfür beispielsweise eine Beprobungsfläche 8 aufweisen.

Die Beprobungseinrichtung 3 kann einen Rollenkörper 9 aufweisen der eingerichtet ist, um den Beprobungsstreifen 7 auf seiner Mantelfläche 10 (vgl. Figur 9) entlang seines Umfangs zu führen, insbesondere mit von der Mantelfläche 10 des Rollenkörpers 9 abgewandter Beprobungsfläche 8. Die Beprobungseinrichtung 3 kann eingerichtet sein, um den Rollenkörper 9 zusammen mit dem Beprobungsstreifen 7 auf der zu prüfenden Oberfläche 2 abzurollen, um die Partikel 5 von der zu prüfenden Oberfläche 2 auf den Beprobungsstreifen 7 zu übertragen.

Die Beprobungseinrichtung 3 weist ein Griffelement 11 für einen Benutzer des Partikelprüfsystems 1 auf. Das Griffelement 11 ist mit einer Rahmenbaugruppe 12 verbunden. Grundsätzlich kann auf ein Griffelement 11 allerdings auch verzichtet werden.

Der Rollenkörper 9 ist um eine Drehachse A (vgl. Figur 9) drehbar gelagert und über ein Gestell 13 mit der Rahmenbaugruppe 12 elastisch verbunden. Dadurch, dass der Rollenkörper 9 in der Beprobungseinrichtung 3 relativ zu der prüfenden Oberfläche 2 elastisch gelagert ist, kann der Anpressdruck des Rollenkörpers 9 auf die zu prüfende Oberfläche 2 vorteilhaft vorgegeben und/oder messtechnisch erfasst werden. Das Gestell 13 kann hierfür über eines oder mehrere elastische Elemente 14, beispielsweise Federelemente oder elastische Polymere, mit der Rahmenbaugruppe 12 verbunden sein. Im Ausführungsbeispiel sind beispielhaft lineare Federn zur Ausbildung der elastischen Elemente 14 dargestellt.

Die Beprobungseinrichtung 3 kann zusammen mit dem Rollenkörper 9 von einem Benutzer möglichst parallel zu der zu prüfenden Oberfläche 2 mit dem gewünschten Anpressdruck über die Oberfläche 2 bewegt werden, wodurch sich der Rollenkörper 9 zusammen mit dem Beprobungsstreifen 7 auf der zu prüfenden Oberfläche 2 abrollt und die Partikel 5 auf seiner Beprobungsfläche 8 aufnimmt. Die Beprobungsfläche 8 kann einen Haftklebstoff 15 (vgl. Figur 9) zur adhäsiven Aufnahme der Partikel 5 aufweisen. Grundsätzlich können beliebige Haftmechanismen realisiert sein, um die Aufnahme der Partikel 5 auf der Beprobungsfläche 8 zu ermöglichen - die Verwendung eines Klebstoffs bzw. des Haftklebstoffs 15 ist lediglich beispielhaft zu verstehen.

Figur 9 verdeutlicht eine abrollende Bewegung des Rollenkörpers 9 auf der zu prüfenden Oberfläche 2 in einer vergrößerten Einzeldarstellung. Der in Figur 9 dargestellte Beprobungsstreifen 7 weist beispielhaft die genannte Beprobungsfläche 8 mit dem Haftklebstoff 15 zur adhäsiven Aufnahme der Partikel 5 auf und ist aus einem lichtdurchlässigen Material gebildet.

Der Beprobungsstreifen 7 kann derart auf der Mantelfläche 10 des Rollenkörpers 9 befestigt sein, dass sich dieser während des Abrollens auf der Oberfläche 2 von dem Rollenkörper 9 löst und auf der Oberfläche 2 verbleibt, wie in Figur 9 dargestellt. Alternativ (bevorzugt) verbleibt der Beprobungsstreifen 7 während der abrollenden Bewegung des Rollenkörpers 9 allerdings auf der Mantelfläche 10 und nimmt die Partikel 5 von der Oberfläche 2 lediglich auf, während der Rollenkörper 9 über die Oberfläche 2 bewegt wird.

Die Beprobungseinrichtung 3 kann eine erste Messeinrichtung 16 (vgl. z. B. Figur 5) aufweisen die ausgebildet ist, um eine Rotationsbewegung des Rollenkörpers 9 zu erfassen. Beispielhaft weist die erste Messeinrichtung 16 in den Ausführungsbeispielen einen optischen Sensor 17 auf, um den Drehwinkel des Rollenkörpers 9, die Umdrehungszahl des Rollenkörpers 9 und/oder die Winkelgeschwindigkeit des Rollenkörpers 9 anhand von optischen Markern 18 auf dem Rollenkörper 9 zu erfassen. In den Ausführungsbeispielen ist beispielhaft ein einzelner Marker 18 auf dem Rollenkörper 9 dargestellt; grundsätzlich können beliebig viele Marker 18 vorgesehen sein, um den Drehwinkel bzw. eine Änderung des Drehwinkels möglichst kontinuierlich zu erfassen. Alternativ zu einem optischen Sensor 17 kann beispielsweise auch ein magnetischer Sensor (z. B. Reed-Sensor) oder ein sonstiger Sensor vorgesehen sein. Es können auch mehrere erste Messeinrichtungen 16 mit jeweils zumindest einem Sensor vorgesehen sein.

Die Beprobungseinrichtung 3 kann alternativ oder zusätzlich zu der ersten Messeinrichtung 16 eine zweite Messeinrichtung 19 aufweisen die ausgebildet ist, um den Anpressdruck des Rollenkörpers 9 auf die zu prüfende Oberfläche 2 zu erfassen. Hierzu kann die zweite Messeinrichtung 19 beispielsweise einen Kraftaufnehmer 20 aufweisen, vorzugsweise einen Federkörper-Kraftaufnehmer, einen elektrodynamischen Kraftaufnehmer oder einen Piezo-Kraftaufnehmer. Es können insbesondere auch mehrere zweite Messeinrichtungen 19 mit jeweils einem oder mehreren Sensoren bzw. Kraftaufnehmern 20 vorgesehen sein. Beispielsweise kann die Anzahl zweiter Messeinrichtungen 19 der Anzahl der elastischen Aufhängepunkte des Gestells 13 an der Rahmenbaugruppe 12 entsprechen, wie in den Ausführungsbeispielen dargestellt. Grundsätzlich kann die Messung des Anpressdrucks allerdings auch nur an einem einzigen Aufhängepunkt bzw. an einem einzigen elastischen Element 14 vorgesehen sein.

Die Messeinrichtungen 16, 19 bzw. deren Sensoren 17, 20 können beispielsweise an dem Gestell 13 oder an der Rahmenbaugruppe 12 befestigt sein. Die Messeinrichtungen 16, 19 bzw. die Sensoren 17, 20 sind in den Ausführungsbeispielen lediglich schematisch und jeweils als Black Box gezeigt.

Die mittels der ersten Messeinrichtung 16 und/oder mittels der zweiten Messeinrichtung 19 erfassten Informationen können einem Benutzer der Beprobungseinrichtung 3 zur Verfügung gestellt werden. Hierfür kann beispielsweise die dargestellte elektronische Anzeige 21 vorgesehen sein. Anhand der erfassten Daten zu der Rotationsbewegung und/oder zu dem Anpressdruck wird der Benutzer in die Lage versetzt, den Anpressdruck und/oder die Rotationsbewegung zu optimieren und konstant zu halten. Hierdurch kann das Beprobungsergebnis reproduzierbarer und damit verbessert sein.

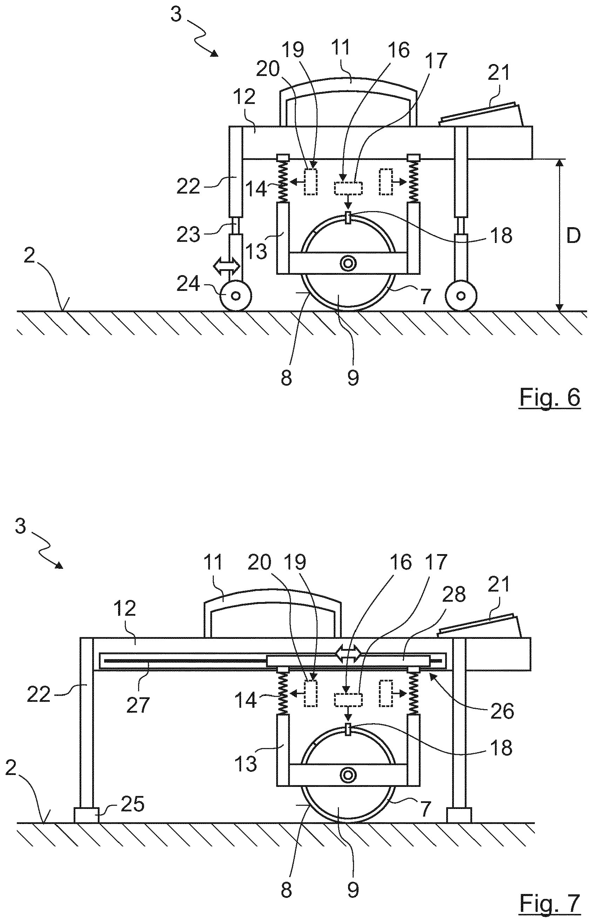

Figur 6 zeigt ein zweites Ausführungsbeispiel einer erfindungsgemäßen Beprobungseinrichtung 3. Um das Beprobungsergebnis weiter zu verbessern und insbesondere von dem Benutzer des Partikelprüfsystems 1 weiter zu entkoppeln, kann vorgesehen sein, dass die Beprobungseinrichtung 3 einen Führungsrahmen 22 aufweist, um die Beprobungseinrichtung 3 auf der zu prüfenden Oberfläche 2 oder neben der zu prüfenden Oberfläche 2 aufzusetzen. Durch den Führungsrahmen 22 kann der Abstand der Rahmenbaugruppe 12 von der zu prüfenden Oberfläche 2 und damit der Anpressdruck des Rollenkörpers 9 definiert vorgegeben werden. Der Anpressdruck kann beispielsweise durch Modifikation des Abstands D der Rahmenbaugruppe 12 von der zu prüfenden Oberfläche 2 bzw. durch Anpassung der Länge der einzelnen Schenkel des Führungsrahmens 22 vorgegeben werden. Hierzu können die Schenkel des Führungsrahmens 22 in ihrer Länge einstellbar sein, beispielsweise teleskopisch verstellbar sein oder - wie dargestellt - eine Stellschraube 23 aufweisen. Grundsätzlich kann die Einstellung des Anpressdrucks aber auch auf andere Weise erfolgen, beispielsweise durch eine Modifikation der elastischen Elemente 14 (z. B. durch eine Erhöhung der Federspannung).

Der Führungsrahmen 22 kann auf der zu prüfenden Oberfläche 2 oder neben der zu prüfenden Oberfläche 2 parallel zu der zu prüfenden Oberfläche 2 verschiebbar sein, um den Rollenkörper 9 zusammen mit dem Beprobungsstreifen 7 auf der zu prüfenden Oberfläche 2 abzurollen. Hierzu weist der Führungsrahmen 22 im Ausführungsbeispiel der Figur 6 entsprechend geeignete Räder 24 auf, um einen möglichst geringen Reibungswiderstand und damit eine schonende Verschiebbarkeit zu gewährleisten.

Die Beprobungseinrichtung 3 des zweiten Ausführungsbeispiels der Figur 6 ermöglicht es, den Anpressdruck während der Beprobung der Oberfläche 2 vollständig von dem Benutzer zu entkoppeln. Hierdurch kann insbesondere ein konstanter und definiert vorgegebener Anpressdruck während der gesamten Beprobung gewährleistet sein.

Eine weitere Verbesserung der Beprobung kann durch das in Figur 7 dargestellte dritte Ausführungsbeispiel der Beprobungseinrichtung möglich sein. Anstelle der Räder 24 weist der in Figur 7 dargestellte Führungsrahmen 22 einfache Aufsetzinterfaces 25 auf.

Der Führungsrahmen 22 ist in Figur 7 (und auch in der nachfolgenden Figur 8) aus Gründen einer vereinfachten Darstellung nicht längenverstellbar gezeigt. Die Führungsrahmen 22 der in den Ausführungsbeispielen der Figuren 7 und 8 gezeigten Beprobungseinrichtungen 3 können allerdings ebenfalls längenverstellbar sein und beispielsweise die zuvor beschriebene Stellschraube 23 aufweisen.

Eine Aktuatoreinrichtung 26 der Beprobungseinrichtung 3 ist eingerichtet, um den Rollenkörper 9 parallel zu der zu prüfenden Oberfläche 2 zu verschieben, um den Rollenkörper 9 zusammen mit dem Beprobungsstreifen 7 automatisiert auf der zu prüfenden Oberfläche 2 abzurollen. Die Rotationsbewegung des Rollenkörpers 9 wird somit nicht mehr von dem Benutzer ausgeführt und ist damit ebenfalls von dem Benutzer entkoppelt, was abermals das Beprobungsergebnis verbessern kann. Die Aktuatoreinrichtung 26 kann ein Schienensystem aufweisen, wobei die Rahmenbaugruppe 12 eine oder mehrere Schienen 27 umfasst, um den Rollenkörper 9 zusammen mit seinem Gestell 13 linear zu verschieben. Der Rollenkörper 9 kann in der Schiene 27 oder in den Schienen 27 mittels einer Translatoreinheit 28 geführt sein.

Zur Auswertung kann der Benutzer den Beprobungsstreifen 7 von dem Rollenkörper 9 und/oder von der Oberfläche 2 entnehmen und der Auswertungseinrichtung 4 zuführen (vgl. Figur 4). Gegebenenfalls kann der gesamte Rollenkörper 9 aus der Beprobungseinrichtung 3 entnehmbar sein. Die Auswertungseinrichtung 4 kann insbesondere ein Mikroskop 29 aufweisen, vorzugsweise ein Lichtmikroskop. Die Steuereinrichtung 6 kann eingerichtet sein, um die von dem Mikroskop 29 bzw. von der Auswertungseinrichtung 4 erfassten Bildinformationen automatisch auszuwerten.

Der Beprobungsstreifen 7 kann in einer besonders bevorzugten Variante aus einem lichtdurchlässigen Material ausgebildet sein. Demnach kann sich zur Auswertung der aufgenommenen Partikel 5 insbesondere die Durchlichtmikroskopie gut eignen, wonach eine Lichtquelle 30 des Mikroskops 29 den Beprobungsstreifen 7 ausgehend von seiner der Beprobungsfläche 8 gegenüberliegenden Seite ausreichend beleuchtet. Durch die Durchlichtmikroskopie können Überstrahlungseffekte, die beispielsweise bei Streiflicht auftreten, vermieden werden.

In Figur 8 ist ein viertes Ausführungsbeispiel der Erfindung dargestellt, bei dem die Auswertungseinrichtung 4 bereits in die Beprobungseinrichtung 3 integriert ist. Die Messeinrichtungen 16, 19 sind in Figur 8 aus Gründen der Darstellbarkeit ausgeblendet.

Der Rollenkörper 9 und der Beprobungsstreifen 7 sind in Figur 8 jeweils aus einem lichtdurchlässigen Material ausgebildet. Eine innerhalb des Rollenkörpers 9 angeordnete Lichtquelle 30 erzeugt bereits während der Beprobung Durchlicht, um die auf dem Beprobungsstreifen 7 aufgenommenen Partikel 5 noch während der Beprobung durch ein zusammen mit dem Gestell 13 des Rollenkörpers 9 entlang der Rahmenbaugruppe 12 der Beprobungseinrichtung 3 bewegbaren Mikroskop 29 auszuwerten.

Auf diese Weise kann auch der Prozess der Entnahme des Beprobungsstreifens 7 aus der Beprobungseinrichtung 3 von dem Benutzer entkoppelt werden bzw. entfallen und der Beprobungsprozess beschleunigt sein.

Die Beprobung bzw. die Rotationsbewegung des Rollenkörpers 9 kann auf die Auswertungseinrichtung 4 abgestimmt oder mit der Auswertungseinrichtung 4 synchronisiert sein, um der Auswertungseinrichtung 4 ausreichend Zeit für die Auswertung der Probe bzw. der Partikel 5 zur Verfügung zu stellen. Beispielsweise kann die Rotationsbewegung des Rollenkörpers 9 auch getaktet ablaufen, wobei der Rollenkörper 9 während eines Auswertungszyklus stillsteht und erst anschließend weiterbewegt wird.

## Patentansprüche

1. Partikelprüfsystem (1) zur Prüfung einer Partikelbelastung einer Oberfläche (2), aufweisend einen Beprobungsstreifen (7) zur Aufnahme von Partikeln (5) und eine Beprobungseinrichtung (3), wobei die Beprobungseinrichtung (3) einen Rollenkörper (9) aufweist der eingerichtet ist, um den Beprobungsstreifen (7) auf seiner Mantelfläche (10) zu führen, und wobei die Beprobungseinrichtung (3) eingerichtet ist, um den Rollenkörper (9) zusammen mit dem Beprobungsstreifen (7) auf der zu prüfenden Oberfläche (2) abzurollen, um Partikel (5) von der zu prüfenden Oberfläche (2) auf den Beprobungsstreifen (7) zu übertragen, wobei die Beprobungseinrichtung (3)
a) eine erste Messeinrichtung (16) aufweist die ausgebildet ist, um eine Rotationsbewegung des Rollenkörpers (9) zu erfassen; und/oder
b) eine zweite Messeinrichtung (19) aufweist die ausgebildet ist, um einen Anpressdruck des Rollenkörpers (9) auf die zu prüfende Oberfläche (2) zu erfassen;
**dadurch gekennzeichnet, dass** die Beprobungseinrichtung (3) einen Führungsrahmen (22) aufweist, um die Beprobungseinrichtung (3) auf der zu prüfenden Oberfläche (2) oder neben der zu prüfenden Oberfläche (2) aufzusetzen, wobei der Führungsrahmen (22) wenigstens ein Aufsetzinterface (24, 25) aufweist, mit dem der Führungsrahmen (22) auf der zu prüfenden Oberfläche (2) oder auf einer sonstigen Oberfläche aufliegt, und wobei der Rollenkörper (9) in der Beprobungseinrichtung (3) relativ zu der zu prüfenden Oberfläche (2) elastisch gelagert ist.

2. Partikelprüfsystem (1) nach Anspruch 1, **dadurch gekennzeichnet, dass** der Beprobungsstreifen (7) eine Beprobungsfläche (8) aufweist, die zur adhäsiven Aufnahme der Partikel (5) von der zu prüfenden Oberfläche (2) ausgebildet ist, wobei die Beprobungsfläche (8) von der Mantelfläche (10) des Rollenkörpers (9) abgewandt ist, wenn der Beprobungsstreifen (7) entlang der Mantelfläche (10) des Rollenkörpers (9) geführt ist.

3. Partikelprüfsystem (1) nach Anspruch 2, **dadurch gekennzeichnet, dass** die Beprobungsfläche (8) einen Haftklebstoff (15) zur adhäsiven Aufnahme der Partikel (5) von der zu prüfenden Oberfläche (2) aufweist.

4. Partikelprüfsystem (1) nach einem der Ansprüche 1 bis 3, **dadurch gekennzeichnet, dass** der Beprobungsstreifen (7) aus einem lichtdurchlässigen Material ausgebildet ist.

5. Partikelprüfsystem (1) nach einem der Ansprüche 1 bis 4, **dadurch gekennzeichnet, dass** der Rollenkörper (9) in der Beprobungseinrichtung (3) relativ zu der zu prüfenden Oberfläche (2) federgelagert ist.

6. Partikelprüfsystem (1) nach einem der Ansprüche 1 bis 5, **dadurch gekennzeichnet, dass** die erste Messeinrichtung (16) einen optischen Sensor (17) oder einen magnetischen Sensor aufweist, um den Drehwinkel des Rollenkörpers (9), die Umdrehungszahl des Rollenkörpers (9) und/oder die Winkelgeschwindigkeit des Rollenkörpers (9) zu erfassen.

7. Partikelprüfsystem (1) nach einem der Ansprüche 1 bis 6, **dadurch gekennzeichnet, dass** die zweite Messeinrichtung (19) einen Kraftaufnehmer (20) aufweist, vorzugsweise einen Federkörper-Kraftaufnehmer, einen elektrodynamischen Kraftaufnehmer oder einen Piezo-Kraftaufnehmer, um den Anpressdruck des Rollenkörpers (9) auf die zu prüfende Oberfläche (2) zu erfassen.

8. Partikelprüfsystem (1) nach einem der Ansprüche 1 bis 7, **dadurch gekennzeichnet, dass** die Beprobungseinrichtung (3) eine Anzeige (21), insbesondere eine elektronische Anzeige (21), aufweist, um die mittels der ersten Messeinrichtung (16) und/oder die mittels der zweiten Messeinrichtung (19) erfassten Informationen einem Benutzer der Beprobungseinrichtung (3) anzuzeigen.

9. Partikelprüfsystem (1) nach einem der Ansprüche 1 bis 8, **dadurch gekennzeichnet, dass** der Führungsrahmen (22) auf der zu prüfenden Oberfläche (2) oder neben der zu prüfenden Oberfläche (2) parallel zu der zu prüfenden Oberfläche (2) verschiebbar ist, um den Rollenkörper (9) zusammen mit dem Beprobungsstreifen (7) auf der zu prüfenden Oberfläche (2) abzurollen.

10. Partikelprüfsystem (1) nach einem der Ansprüche 1 bis 9, **dadurch gekennzeichnet, dass** die Beprobungseinrichtung (3) eine Aktuatoreinrichtung (26) aufweist, um den Rollenkörper (9) parallel zu der zu prüfenden Oberfläche (2) zu verschieben, um den Rollenkörper (9) zusammen mit dem Beprobungsstreifen (7) automatisiert auf der zu prüfenden Oberfläche (2) abzurollen.

11. Partikelprüfsystem (1) nach einem der Ansprüche 1 bis 10, **dadurch gekennzeichnet, dass** das Partikelprüfsystem (1) eine Auswertungseinrichtung (4) aufweist die ausgebildet ist, um die von dem Beprobungsstreifen (7) aufgenommenen Partikel (5) nach Partikelgröße, Partikelart, Partikelmenge und/oder Partikelverteilung auszuwerten.

12. Partikelprüfsystem (1) nach Anspruch 11, **dadurch gekennzeichnet, dass** die Auswertungseinrichtung (4) ein Mikroskop (29) umfasst, vorzugsweise ein Durchlichtmikroskop.

13. Projektionsbelichtungsanlage (100, 200, 400) für die Halbleiterlithographie, wobei ein Partikelprüfsystem (1) nach einem der Ansprüche 1 bis 12 zur Prüfung einer Partikelbelastung einer Oberfläche (2) einer Komponente der Projektionsbelichtungsanlage (100, 200, 400) vorgesehen ist, insbesondere zur Prüfung einer Oberfläche (2) eines optischen Elements (415, 416, 418, 419, 420, 108, 201) einer Optik (107, 403, 408) der Projektionsbelichtungsanlage (100, 200, 400).

14. Verfahren zur Prüfung einer Partikelbelastung einer Oberfläche (2), wonach ein Rollenkörper (9) einer Beprobungseinrichtung (3) zusammen mit einem auf einer Mantelfläche (10) des Rollenkörpers (9) geführten Beprobungsstreifen (7) auf der zu prüfenden Oberfläche (2) abgerollt wird, um die Partikel (5) von der zu prüfenden Oberfläche (2) auf den Beprobungsstreifen (7) zu übertragen, wobei die Beprobungseinrichtung (3) über einen Führungsrahmen (22) auf der zu prüfenden Oberfläche (2) oder neben der zu prüfenden Oberfläche aufgesetzt wird, wobei der Führungsrahmen (22) wenigstens ein Aufsetzinterface (24, 25) aufweist, mit dem der Führungsrahmen (22) auf der zu prüfenden Oberfläche (2) oder auf einer sonstigen Oberfläche aufliegt, wobei der Rollenkörper (9) in der Beprobungseinrichtung (3) relativ zu der zu prüfenden Oberfläche (2) elastisch gelagert wird, und wobei
a) eine erste Messeinrichtung (16) der Beprobungseinrichtung (3) eine Rotationsbewegung des Rollenkörpers (9) erfasst; und/oder
b) eine zweite Messeinrichtung (19) der Beprobungseinrichtung (3) einen Anpressdruck des Rollenkörpers (9) auf die zu prüfende Oberfläche (2) erfasst.

15. Computerprogrammprodukt mit Programmcodemitteln, um ein Verfahren gemäß Anspruch 14 durchzuführen, wenn das Programm auf einer Steuereinrichtung (6) eines Partikelprüfsystems (1) ausgeführt wird.

## Claims

1. Particle examination system (1) for examining a particle contamination of a surface (2), having a sampling strip (7) for uptake of particles (5) and a sampling device (3), wherein the sampling device (3) has a roller body (9) set up to guide the sampling strip (7) over its outer surface (10), and wherein the sampling device (3) is set up to roll the roller body (9) together with the sampling strip (7) against the surface (2) to be examined, in order to transfer particles (5) from the surface (2) to be examined to the sampling strip (7), wherein the sampling device (3)
a) has a first measuring device (16) designed to detect any rotational movement of the roller body (9); and/or
b) has a second measuring device (19) designed to detect any contact pressure of the roller body (9) on the surface (2) to be examined;
**characterized in that** the sampling device (3) has a guide frame (22) in order to position the sampling device (3) on the surface (2) to be examined or alongside the surface (2) to be examined, wherein the guide frame (22) has at least one positioning interface (24, 25) by which the guide frame (22) lies on the surface (2) to be examined or on another surface, and wherein the roller body (9) is mounted elastically relative to the surface (2) to be examined in the sampling device (3).

2. Particle examination system (1) according to Claim 1, **characterized in that** the sampling strip (7) has a sampling surface (8) designed for adhesive uptake of the particles (5) from the surface (2) to be examined, wherein the sampling surface (8) is remote from the outer surface (10) of the roller body (9) when the sampling strip (7) is guided along the outer surface (10) of the roller body (9).

3. Particle examination system (1) according to Claim 2, **characterized in that** the sampling surface (8) has a pressure-sensitive adhesive (15) for adhesive uptake of the particles (5) from the surface (2) to be examined.

4. Particle examination system (1) according to any of Claims 1 to 3, **characterized in that** the sampling strip (7) is formed from a translucent material.

5. Particle examination system (1) according to any of Claims 1 to 4, **characterized in that** the roller body (9) is spring-mounted relative to the surface (2) to be examined in the sampling device (3).

6. Particle examination system (1) according to any of Claims 1 to 5, **characterized in that** the first measuring device (16) has an optical sensor (17) or a magnetic sensor in order to detect the angle of rotation of the roller body (9), the speed of rotation of the roller body (9) and/or the angular speed of the roller body (9).

7. Particle examination system (1) according to any of Claims 1 to 6, **characterized in that** the second measuring device (19) has a force transducer (20), preferably a force transducer with a spring element, an electrodynamic force transducer or a piezo force transducer, in order to detect the contact pressure of the roller body (9) on the surface (2) to be examined.

8. Particle examination system (1) according to any of Claims 1 to 7, **characterized in that** the sampling device (3) has a display (21), especially an electronic display (21), in order to display the information detected by means of the first measuring device (16) and/or that detected by means of the second measuring device (19) to a user of the sampling device (3).

9. Particle examination system (1) according to any of Claims 1 to 8, **characterized in that** the guide frame (22) is movable parallel to the surface (2) to be examined on the surface (2) to be examined or alongside the surface (2) to be examined, in order to roll the roller body (9) together with the sampling strip (7) against the surface (2) to be examined.

10. Particle examination system (1) according to any of Claims 1 to 9, **characterized in that** the sampling device (3) has an actuator device (26) in order to move the roller body (9) parallel to the surface (2) to be examined, in order to roll the roller body (9) together with the sampling strip (7) against the surface (2) to be examined in an automated manner.

11. Particle examination system (1) according to any of Claims 1 to 10, **characterized in that** the particle examination system (1) has an evaluation device (4) designed to evaluate the particles (5) taken up by the sampling strip (7) by particle size, particle type, particle amount and/or particle distribution.

12. Particle examination system (1) according to Claim 11, **characterized in that** the evaluation device (4) comprises a microscope (29), preferably a transmitted light microscope.

13. Projection exposure apparatus (100, 200, 400) for semiconductor lithography, wherein a particle examination system (1) according to any of Claims 1 to 12 for examination of a particle contamination of a surface (2) of a component of the projection exposure apparatus (100, 200, 400) is provided, especially for examination of a surface (2) of an optical element (415, 416, 418, 419, 420, 108, 201) of an optical unit (107, 403, 408) of the projection exposure apparatus (100, 200, 400).

14. Method of examining a particle contamination of a surface (2), whereby a roller body (9) of a sampling device (3) is rolled together with a sampling strip (7) guided over an outer surface (10) of the roller body (9) against the surface (2) to be examined, in order to transfer the particles (5) from the surface (2) to be examined to the sampling strip (7), wherein the sampling device (3) is positioned via a guide frame (22) on the surface (2) to be examined or alongside the surface to be examined, wherein the guide frame (22) has at least one positioning interface (24, 25) by which the guide frame (22) lies on the surface (2) to be examined or on another surface, wherein the roller body (9) is mounted elastically relative to the surface (2) to be examined in the sampling device (3), and wherein
a) a first measuring device (16) of the sampling device (3) detects any rotational movement of the roller body (9); and/or
b) a second measuring device (19) of the sampling device (3) detects any contact pressure of the roller body (9) on the surface (2) to be examined.

15. Computer program product with program coding means in order to implement a method according to Claim 14 when the program is executed on a control device (6) of a particle examination system (1).

## Revendications

1. Système de contrôle de particules (1) servant au contrôle d'une charge en particules d'une surface (2), comportant une bande d'échantillonnage (7) destinée à absorber des particules (5) et un dispositif d'échantillonnage (3), le dispositif d'échantillonnage (3) comportant un corps de galet (9) qui est conçu pour guider la bande d'échantillonnage (7) sur sa surface d'enveloppe (10) et le dispositif d'échantillonnage (3) qui est conçu pour dérouler le corps de galet (9) conjointement avec la bande d'échantillonnage (7) sur la surface (2) à contrôler de façon à transmettre les particules (5) de la surface (2) à contrôler jusqu'à la bande d'échantillonnage (7), le dispositif d'échantillonnage comportant (3) :
a) un premier dispositif de mesure (16) qui est réalisé pour détecter un mouvement de rotation du corps de galet (9) ; et/ou
b) un deuxième dispositif de mesure (19) qui est réalisé pour détecter une compression du corps de galet (9) sur la surface (2) à contrôler ;
**caractérisé en ce que** le dispositif d'échantillonnage (3) comporte un cadre de guidage (22) pour placer le dispositif d'échantillonnage (3) sur la surface (2) à contrôler ou à côté de la surface (2) à contrôler, le cadre de guidage (22) comportant au moins une interface de placement (24, 25) à l'aide de laquelle le cadre de guidage (22) repose sur la surface (2) à contrôler ou sur une autre surface et le corps de galet (9) étant disposé de façon élastique dans le dispositif d'échantillonnage (3) par rapport à la surface (2) à contrôler.

2. Système de contrôle de particules (1) selon la revendication 1, **caractérisé en ce que** la bande d'échantillonnage (7) comporte une surface d'échantillonnage (8) servant à l'absorption adhésive des particules (5) provenant de la surface (2) à contrôler, la surface d'échantillonnage (8) étant infléchie depuis la surface d'enveloppe (10) du corps de galet (9) lorsque la bande d'échantillonnage (7) est guidée le long de la surface d'enveloppe (10) du corps de galet (9).

3. Système de contrôle de particules (1) selon la revendication 2, **caractérisé en ce que** la surface d'échantillonnage (8) comporte une colle adhérente (15) permettant d'absorber par adhésion les particules (5) provenant de la surface (2) à contrôler.

4. Système de contrôle de particules (1) selon l'une quelconque des revendications 1 à 3, **caractérisé en ce que** la bande d'échantillonnage (7) est réalisée à partir d'un matériau translucide.

5. Système de contrôle de particules (1) selon l'une quelconque des revendications 1 à 4, **caractérisé en ce que** le corps de galet (9) est disposé par ressort dans le dispositif d'échantillonnage (3) par rapport à la surface (2) à contrôler.

6. Système de contrôle de particules (1) selon l'une quelconque des revendications 1 à 5, **caractérisé en ce que** le premier dispositif de mesure (16) comporte un capteur optique (17) ou un capteur magnétique afin de détecter l'angle de rotation du corps de galet (9), la vitesse de rotation du corps de galet (9) et/ou la vitesse angulaire du corps de galet (9).

7. Système de contrôle de particules (1) selon l'une quelconque des revendications 1 à 6, **caractérisé en ce que** le deuxième dispositif de mesure (19) comporte un dynamomètre (20), de préférence un dynamomètre de corps de ressort, un dynamomètre électrodynamique ou un dynamomètre piézoélectrique, pour détecter la compression du corps de galet (9) sur la surface (2) à contrôler.

8. Système de contrôle de particules (1) selon l'une quelconque des revendications 1 à 7, **caractérisé en ce que** le dispositif d'échantillonnage (3) comporte un affichage (21), notamment un affichage électronique (21), pour afficher les informations détectées à l'aide du premier dispositif de mesure (16) et/ou les informations détectées à l'aide du deuxième dispositif de mesure (19) à un utilisateur du dispositif d'échantillonnage (3).

9. Système de contrôle de particules (1) selon l'une quelconque des revendications 1 à 8, **caractérisé en ce que** le cadre de guidage (22) peut être déplacé sur la surface (2) à contrôler ou à côté de la surface (2) à contrôler parallèlement à la surface (2) à contrôler pour dérouler le corps de galet (9) conjointement avec la bande d'échantillonnage (7) sur la surface (2) à contrôler.

10. Système de contrôle de particules (1) selon l'une quelconque des revendications 1 à 9, **caractérisé en ce que** le dispositif d'échantillonnage (3) comporte un dispositif actionneur (26) destiné à faire coulisser le corps de galet (9) parallèlement à la surface (2) à contrôler afin de dérouler le corps de galet (9) conjointement avec la bande d'échantillonnage (7) de façon automatisée sur la surface (2) à contrôler.

11. Système de contrôle de particules (1) selon l'une quelconque des revendications 1 à 10, **caractérisé en ce que** le système de contrôle de particules (1) comporte un dispositif d'analyse (4) qui est réalisé pour analyser les particules (5) absorbées par la bande d'échantillonnage (7) en fonction de leur taille de particule, de leur type de particule, de leur quantité de particules et de leur répartition en particules.

12. Système de contrôle de particules (1) selon la revendication 11, **caractérisé en ce que** le dispositif d'analyse (4) comprend un microscope (29), de préférence un microscope à lumière transmise.

13. Installation d'éclairage par projection (100, 200, 400) pour la lithographique de semi-conducteur, un système de contrôle de particules (1) étant prévu selon l'une quelconque des revendications 1 à 12 servant au contrôle d'une charge en particules d'une surface (2) d'un composant d'une installation d'éclairage par projection (100, 200, 400), servant notamment au contrôle d'une surface (2) d'un élément optique (415, 416, 418, 419, 420, 108, 201) d'un système optique (107, 403, 408) de l'installation d'éclairage par projection (100, 200, 400).

14. Procédé servant au contrôle d'une charge en particules d'une surface (2), à la suite de quoi un corps de galet (9) d'un dispositif d'échantillonnage (3) est déroulé sur la surface (2) à contrôler conjointement avec une bande d'échantillonnage (7) placée sur la surface (2) à contrôler, pour transmettre les particules (5) de la surface (2) à contrôler sur la bande d'échantillonnage (7), le dispositif d'échantillonnage (3) étant placé via un cadre de guidage (22) sur la surface (2) à contrôler ou à côté de la surface à contrôler, le cadre de guidage (22) comportant au moins une interface de placement (24, 25) à l'aide de laquelle le cadre de guidage (22) repose sur la surface (2) à contrôler ou sur une autre surface, le corps de galet (9) étant disposé de façon élastique dans le dispositif d'échantillonnage (3) par rapport à la surface (2) à contrôler ; et
a) un premier dispositif de mesure (16) du dispositif d'échantillonnage (3) détectant un mouvement de rotation du corps de galet (9) ; et/ou
b) un deuxième dispositif de mesure (19) du dispositif d'échantillonnage (3) détectant une compression du corps de galet (9) sur la surface (2) à contrôler.

15. Produit de programme informatique équipé de moyens de code de programmation pour mettre en œuvre un procédé selon la revendication 14 lorsque le programme est installé sur un dispositif de commande (6) d'un système de contrôle de particules (1).
